# Europäisches Patentamt

# European Patent Office

# Office européen des brevets

(11) Veröffentlichungsnummer: **0 166 386**
**A2**

(12) # EUROPÄISCHE PATENTANMELDUNG

(21) Anmeldenummer: 85107660.4

(51) Int. Cl.⁴: **H 01 L 27/06**

(22) Anmeldetag: 21.06.85

(30) Priorität: 29.06.84 DE 3424094

(43) Veröffentlichungstag der Anmeldung: 02.01.86
**Patentblatt 86/1**

(84) Benannte Vertragsstaaten: **AT CH DE FR GB IT LI NL**

(71) Anmelder: **Siemens Aktiengesellschaft, Berlin und München Wittelsbacherplatz 2, D-8000 München 2 (DE)**

(72) Erfinder: **Pfleiderer, Hans-Jörg, Dr. Dipl.-Ing., Franz-Krinninger-Weg 23, D-8011 Zorneding (DE)**
Erfinder: **Schütz, Alfred, Dr. Dipl.-Ing., Lindenstrasse 22, D-8011 Zorneding (DE)**

(54) **Integrierte Schaltung in komplementärer Schaltungstechnik.**

(57) Integrierte Schaltung in komplementärer Schaltungstechnik mit zwei Feldeffekttransistoren (T1, T2) unterschiedlicher Kanaltypen, von denen der eine (T2) in einem dotierten Halbleiterkörper (1) eines ersten Leitfähigkeitstyps und der andere (T1) in einer in diesen vorgesehenen Halbleiterzone (2) eines zweiten Leitfähigkeitstyps angeordnet ist. Angestrebt wird hierbei eine Sicherheit gegen thermische Überlastungen, die bei Überspannungen an dem einen Anschlussgebiet des in der Halbleiterzone befindlichen Feldeffekttransistors (T1) durch «latch-up»-Einflüsse auftreten können. Erreicht wird das durch die Anordnung eines Metallkontakts (12) auf der Oberfläche eines in den Halbleiterkörper (1) eingefügten entgegengesetzt zu diesem dotierten Halbleitergebiets (2'), der mit diesem eine Schottky-Diode (D) bildet und mit dem genannten Anschlussgebiet des in der Halbleiterzone (2) befindlichen Feldeffekttransistors (T1) verbunden ist, während das Halbleitergebiet (2') mit der Versorgungsspannung ($V_{DD}$) beschaltet ist. Das Anwendungsgebiet umfasst CMOS-Schaltungen.

Siemens Aktiengesellschaft          Unser Zeichen
Berlin und München                  VPA 84 P 1 4 7 1 E

Integrierte Schaltung in komplementärer Schaltungstechnik _____

Die Erfindung bezieht sich auf eine integrierte Schaltung in komplementärer Schaltungstechnik nach dem Oberbegriff des Patentanspruchs 1 und auf ein Verfahren zu
deren Herstellung.

Bei integrierten Schaltungen dieser Art besteht die
Schwierigkeit, daß zwischen einem Anschluß eines in der
wannenförmigen Halbleiterzone liegenden Feldeffekttransistors des ersten Kanaltyps und einem Anschluß eines
außerhalb dieser Zone plazierten Feldeffekttransistors
des zweiten Kanaltyps im allgemeinen vier aufeinanderfolgende Halbleiterschichten alternierender Leitfähigkeitstypen vorhanden sind, wobei das eine Anschlußgebiet
des ersteren Transistors die erste Halbleiterschicht,
die wannenförmige Halbleiterzone die zweite, der Halbleiterkörper die dritte und das eine Anschlußgebiet des
letzteren Transistors die vierte Halbleiterschicht bilden. Gelangt nun eine Überspannung, die die Versorgungsspannung um einen bestimmten Betrag, z.B. 500 mV, übersteigt, an den betrachteten Anschluß des Transistors des
ersten Kanaltyps, kann der pn-Übergang zwischen der ersten und zweiten Halbleiterschicht so weit positiv vorgespannt werden, daß zwischen den Transistoranschlüssen
ein Strompfad entsteht, der auf eine parasitäre Thyristorwirkung (latch up) innerhalb der Vierschichtenstruktur zurückzuführen ist. Dieser Strompfad bleibt dann St 1 Sti/29.5.1984 auch nach einem Abbau der Überspannung bestehen und kann die integrierte Schaltung thermisch überlasten.

Der Erfindung liegt die Aufgabe zugrunde, den vorstehend genannten Nachteil zu beseitigen. Das wird erfindungsgemäß durch eine Ausbildung der integrierten Schaltung nach dem kennzeichnenden Teil des Patentanspruchs 1 erreicht.

Der mit der Erfindung erzielbare Vorteil liegt insbesondere darin, daß die genannte parasitäre Thyristorwirkung durch einfache strukturelle Maßnahmen vermieden wird, die insbesondere bei der Herstellung der Schaltung keine zusätzlichen Verfahrensschritte, sondern nur geringfügige Modifikationen der herkömmlichen Schritte erfordern.

Die Ansprüche 2 bis 4 sind auf bevorzugte Ausgestaltungen und Weiterbildungen der Erfindung gerichtet, während der Anspruch 5 ein vorteilhaftes Verfahren zur Herstellung einer erfindungsgemäßen Schaltung betrifft.

Die Erfindung wird nachfolgend anhand der Zeichnung näher erläutert. Dabei zeigen:

Fig. 1 ein Ausführungsbeispiel der Erfindung,
Fig. 2 ein Schaltbild des Ausführungsbeispiels nach Fig. 1,
Fig. 3 eine erste Modifikation des Ausführungsbeispiels nach Fig. 1,
Fig. 4 eine zweite Modifikation des Ausführungsbeispiels nach Fig. 1 und
Figuren 5 bis 7 einzelne Schritte bei der Herstellung des Ausführungsbeispiels nach Fig. 1.

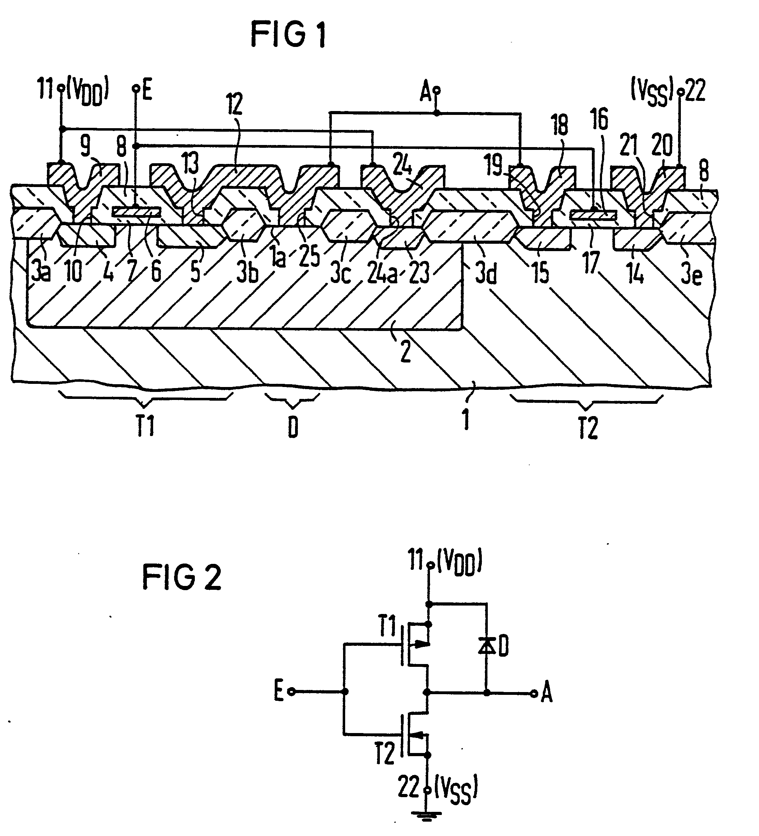

In Fig. 1 ist eine erfindungsgemäße integrierte Schaltung auf einem Körper 1 aus dotiertem Halbleitermaterial, z.B. p-leitendem Silizium, aufgebaut. Der Halbleiterkörper 1 weist eine n-leitende, wannenförmige Halbleiterzone 2 auf, die sich bis zur Grenzfläche 1a von 1 hin erstreckt. An der Grenzfläche 1a befinden sich Feldisolationsbereiche 3a bis 3e , z.B. aus $SiO_2$, zwischen denen sich jeweils Gateisolationsbereiche befinden, die die aktiven Bereiche der Halbleiterschaltung abdecken. In einem ersten aktiven Bereich, der sich innerhalb der lateralen Grenzen der Halbleiterzone 2 befindet, sind $p^+$-dotierte Gebiete 4 und 5 vorgesehen, die das Source- und Draingebiet eines p-Kanal-Feldeffekttransistors T1 bilden. Der zwischen 4 und 5 liegende Kanalbereich wird von einem Gate 6 überdeckt, das mit einem Anschluß E versehen ist und durch eine dünne Gateisolationsschicht 7, z.B. aus $SiO_2$, von der Grenzfläche 1a getrennt ist. Auf einer Zwischenisolationsschicht 8, die das Gate 6 abdeckt, ist eine leitende Belegung 9 aufgebracht, die das Sourcegebiet 4 durch ein Fenster 10 von 8 kontaktiert und mit einem Anschluß 11 versehen ist. Der Anschluß 11 ist dabei mit einer Versorgungsspannung $V_{DD}$ beschaltet. Eine andere, auf 8 aufgebrachte leitende Belegung 12 kontaktiert im Bereich eines Fensters 13 das Draingebiet 5 und ist mit einem Anschluß A verbunden.

In einem zwischen 3d und 3e liegenden aktiven Bereich ist ein n-Kanal-Feldeffekttransistor T2 angeordnet, der $n^+$-dotierte Gebiete 14 und 15 sowie ein Gate 16 aufweist, das durch eine Gateisolationsschicht 17 von dem zwischen 14 und 15 liegenden Kanalbereich getrennt und mit dem Anschluß E verbunden ist. Eine leitende Belegung 18, die das Draingebiet 15 durch ein Fenster 19 der Zwischenisolationsschicht 8 kontaktiert, ist mit A verbunden, während eine leitende Belegung 20, die das Sourcegebiet 14 durch ein Fenster 21 kontaktiert, an einen auf Bezugspotential $V_{SS}$ gelegten Anschluß 22 geführt ist.

In die Halbleiterzone 2 ist ein $n^+$-dotierter Anschlußbereich 23 eingefügt, der von einer oberhalb der Zwischenisolationsschicht 8 angeordneten, mit dem Anschluß 11 verbundenen leitenden Belegung 24 im Bereich eines Fensters 24a kontaktiert wird.

Ein Teil der leitenden Belegung 12 bildet im Bereich eines weiteren Fensters 25 der Zwischenisolationsschicht 8 auf der Oberfläche der n-leitenden Halbleiterzone 2 einen Metallkontakt, der zusammen mit der Halbleiterzone 2 eine Schottky-Diode darstellt. Bei einer n-Dotierungskonzentration von etwa $10^{16} cm^{-3}$ in der Halbleiterzone 2 besteht die leitende Belegung 12 zweckmäßigerweise aus Aluminium. Mit besonderem Vorteil kann die leitende Belegung 12 auch aus Tantalsilizid $(TaSi_2)$ bestehen oder als eine Doppelschicht ausgebildet sein, die eine erste Schicht aus $TaSi_2$ und eine zweite, oberhalb der ersten liegende Schicht aus Aluminium aufweist. Für die leitende Belegung 12 kommen auch andere Materialien in Betracht, die in an sich bekannter Weise für Schottky-Dioden verwendet werden, wie z.B. Platin oder Molybdän. Aluminium oder die genannte Doppelschicht aus $TaSi_2$ und Al haben jedoch den Vorteil, daß sie auch für die Belegungen 9, 18, 20 und 24 herangezogen werden können, so daß sämtliche Belegungen auf der Zwischenisolationsschicht 8 in einem einzigen Verfahrensschritt aufgebracht werden können. Wesentlich ist, daß die vordere Schwellwertspannung $V_D$ der Schottky-Diode D kleiner ist als die vordere Schwellwertspannung des pn-Übergangs zwischen dem Halbleitergebiet 5 und der Halbleiterzone 2, die mit $V_{pn}$ bezeichnet wird.

Wie auch Fig. 2 zeigt, liegen der p-Kanal-Transistor T1 und der n-Kanal-Transistor T2 mit ihren in Serie geschalteten Source-Drain-Strecken an der Versorgungsspannung $V_{DD}$, die über 11 und 22 zugeführt wird, während ihre Gates an den gemeinsamen Anschluß E geschaltet sind. T1 und T2 bilden somit einen Inverter mit dem Eingang E und dem Ausgang A. Dabei ist die Schottky-Diode D, die aus den Teilen 12 und 2 besteht, zwischen den Anschlüssen A und 11 eingefügt. Falls im Betrieb am Inverterausgang A eine Spannung auftritt, die die Versorgungsspannung $V_{DD}$ um einen Betrag übersteigt, der gleich oder größer ist als die vordere Schwellwertspannung $V_{DD}$ der Schottky-Diode D, wird D leitend und begrenzt die Spannung $V_A$ auf den Wert $V_A = V_{DD} + V_D$. Damit wird vermieden, daß $V_A$ weiter ansteigt und einen Wert $V_A = V_{DD} + V_{pn}$ erreicht oder übersteigt, bei dem parasitäre Thyristorwirkungen im Bereich der Vierschichtenstruktur 5, 2, 1 und 14 auftreten, die zur Ausbildung eines Strompfades zwischen den Anschlüssen A und 22 und zu einer thermischen Überlastung der gesamten Struktur führen könnten.

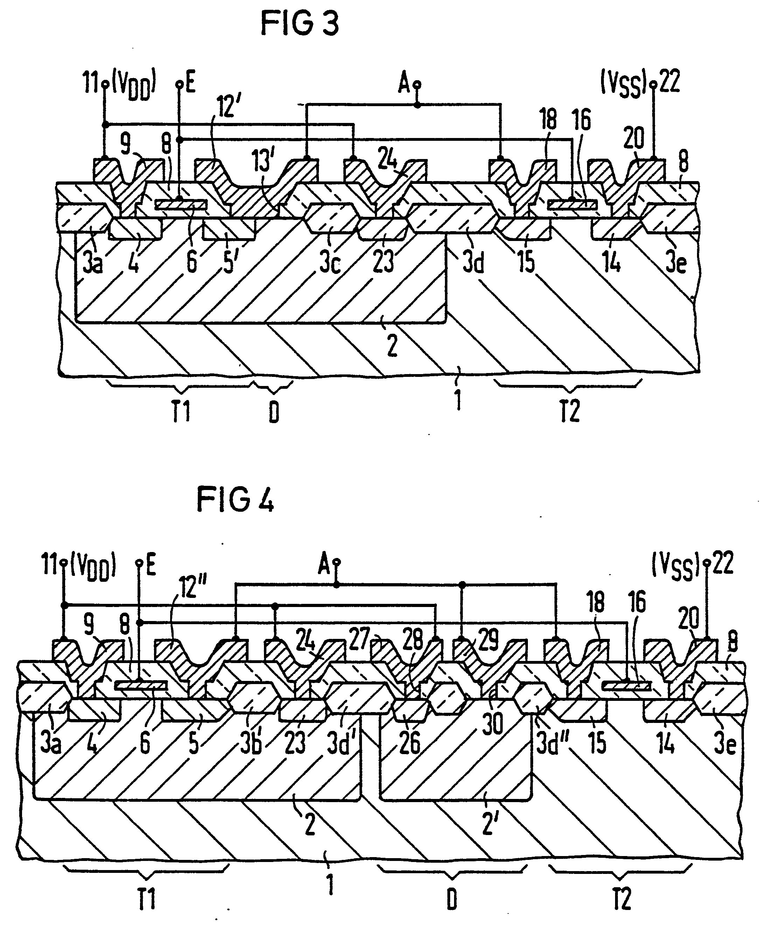

Fig. 3 zeigt eine erste Modifikation des Ausführungsbeispiels nach Fig. 1, die sich von Fig. 1 dadurch unterscheidet, daß die Fenster 13 und 25 zu einem einzigen Fenster 13' zusammengefaßt sind und die leitende Belegung 12, die in Fig. 3 mit 12' bezeichnet ist, im Bereich dieses Fensters sowohl das Draingebiet 5' von T1 als auch die Halbleiterzone 2 kontaktiert. Da das Draingebiet 5' wesentlich stärker dotiert ist als die Halbleiterzone 2, bildet die Belegung 12' auf 5' einen ohmschen Kontakt, mit der Halbleiterzone 2 jedoch die Schottky-Diode D.

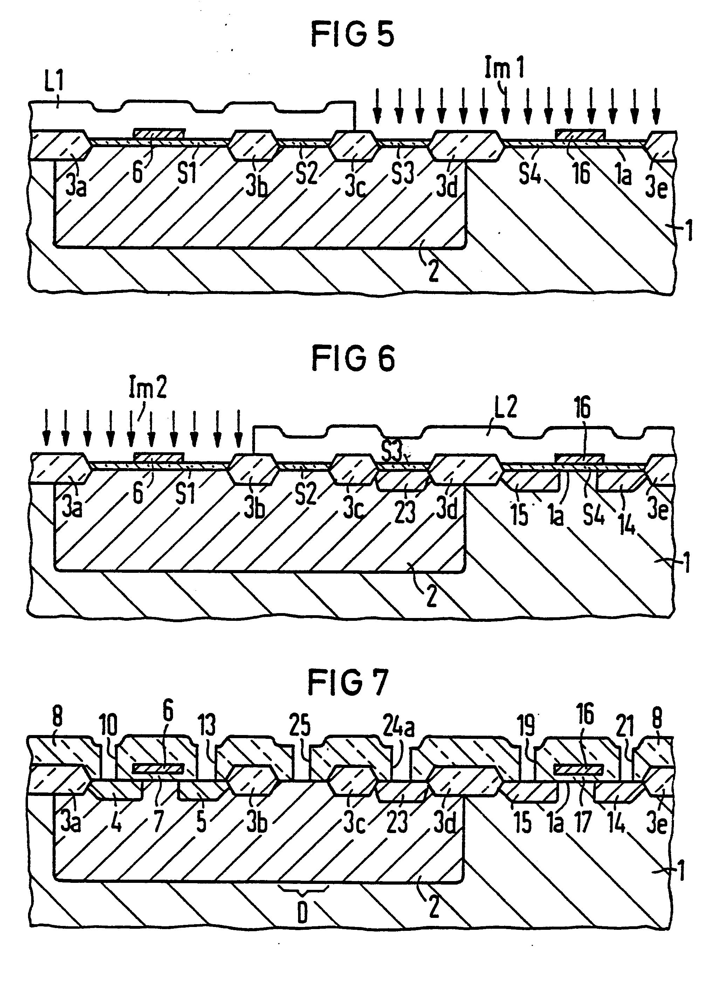

In einer zweiten Modifikation des Ausführungsbeispiels nach Fig. 1, die in Fig. 4 dargestellt ist, liegt die Schottky-Diode D zum Unterschied von Fig. 1 in einer eigenen n-leitenden Halbleiterzone 2', die neben der n-leitenden Halbleiterzone 2 in den Halbleiterkörper 1 eingefügt ist. Die Zone 2' weist etwa denselben Dotierungsgrad auf wie die Zone 2. Die Feldisolationsbereiche 3b und 3c von Fig. 1 sind zu einem gemeinsamen Feldisolationsbereich 3b' zusammengefaßt, wobei die Belegung 12'', die an die Stelle der Belegung 12 von Fig. 1 tritt, nur das Draingbiet 5 von T1 kontaktiert. Der Feldisolationsbereich 3d ist andererseits in zwei Bereiche 3d' und 3d'' aufgeteilt, zwischen denen sich die Halbleiterzone 2' befindet. In diese ist ein $n^+$-dotierter Anschlußbereich 26 eingefügt, der von einer leitenden Belegung 27 im Bereich eines Fensters 28 der Zwischenisolationsschicht 8 kontaktiert wird. Die Belegung 27 ist mit dem Anschluß 11 verbunden. Eine leitende Belegung 29, die aus demselben Material besteht, wie die Belegung 12 in Fig. 1, bildet im Bereich eines Fensters 30 der Zwischenisolationsschicht 8 auf der Halbleiterzone 2' einen Metallkontakt, der zusammen mit 2' die bereits beschriebene Schottky-Diode D darstellt. Die Belegung 29 ist dabei mit dem Anschluß A verbunden.

In den Figuren 3 und 4 sind diejenigen Teile, die bereits anhand von Fig. 1 beschrieben wurden, mit den gleichen Bezugszeichen wie dort versehen. Weiterhin gilt das Schaltbild nach Fig. 2 und die anhand desselben erläuterte Wirkungsweise des Ausführungsbeispiels nach Fig. 1 auch für die Modifikationen nach den Figuren 3 und 4.

Bei der Herstellung einer Schaltung nach Fig. 1 wird zweckmäßigerweise so verfahren, daß in einen Körper 1 aus p-leitendem Silizium mit einer Grunddotierungskonzentration von etwa $10^{15} cm^{-3}$ mittels eines Diffusionsvorgangs eine n-dotierte wannenförmige Halbleiterzone 2 eingefügt wird, die beispielsweise eine Dotierungskonzentration von $10^{16}$cm$^{-3}$ aufweist. Anschließend wird auf der Grenzfläche 1a eine dünne Si$_3$N$_4$-Schicht aufgebracht, die durch fotolithografische Schritte derart strukturiert wird, daß sie nur an den späteren aktiven Halbleiterbereichen bestehen bleibt. Durch thermische Oxidation entstehen an den von der Si$_3$N$_4$-Schicht nicht bedeckten Stellen des Körpers 1 Feldisolationsbereiche 3a bis 3e aus SiO$_2$. Nach dem Entfernen der noch vorhandenen Si$_3$N$_4$-Schichtteile werden auf den aktiven Bereichen von 1 im Wege einer thermischen Oxidation Gateoxidschichten S1 bis S4 aufgewachsen, die die obengenannten Gateoxidbereiche bilden. Aus einer ganzflächig aufgebrachten polykristallinen Siliziumschicht werden dann mittels fotolithografischer Schritte auf den Gateoxidschichten S1 und S4 die Gates 6 und 16 der Feldeffekttransistoren T1 und T2 strukturiert.

Im Anschluß hieran werden gemäß Fig. 5 die n$^+$-dotierten Gebiete 14 und 15 von T2 und das Anschlußgebiet 23 durch eine Ionenimplantation erzeugt, die durch Pfeile Im1 angedeutet ist. Dabei ist der linksseitige, bis zur Mitte des Dickschichtbereichs 3c reichende Teil des Halbleiterkörpers 1 durch eine Fotolackschicht L1 abgedeckt.

Sodann wird L1 entfernt und, wie Fig. 6 zeigt, eine weitere Fotolackschicht L2 aufgebracht, die den rechtsseitigen Teil von 1 bis zur Mitte des Dickschichtbereichs 3b abdeckt, wobei mittels einer Ionenimplantation, die durch Pfeile Im2 angedeutet ist, die p$^+$-dotierten Bereiche 4 und 5 von T1 entstehen.

Wie aus Fig. 7 hervorgeht, wird in einem sich anschliessenden Verfahrensschritt eine Zwischenisolationsschicht

8 aus $SiO_2$ mittels einer Abscheidetechnik aufgebracht, die oberhalb der Gebiete 4, 5, 14 und 15 sowie des Anschlußbereichs 23 und zwischen den Feldisolationsbereichen 3b und 3c mit Fenstern 10, 13, 21, 19, 24a und 25 versehen wird. Diese Fenster werden bis zur Grenzschicht 1a durchgeätzt, so daß auch die in Fig. 6 angedeuteten Gateisolationsschichten S1 bis S4 geöffnet werden. Aus Gründen einer einfachen Darstellung werden die Gateisolationsschichten S1 und S4 in Fig. 7 und Fig. 1 nicht mehr eigens dargestellt, sondern mit den Bezugszeichen 7 und 17 versehen, soweit sie unterhalb der Gates 6 und 16 liegen. Die übrigen Teile von S1 und S4 sowie die Schichten S2 und S3 werden in die Zwischenisolationsschicht 8 einbezogen und mit dieser als eine einheitliche Isolationsschicht dargestellt.

Nachfolgend werden die leitenden Belegungen 9, 12, 24, 18 und 20 aufgebracht, was vorzugsweise durch eine entsprechende Strukturierung einer ganzflächigen Belegung mittels fotolithografischer Schritte geschieht. Die Belegungen 9 und 24 werden schließlich mit dem Anschluß 11 versehen, die Belegung 20 mit dem Anschluß 22, die Gates 6 und 16 mit dem Anschluß E und die Belegungen 12 und 18 mit dem Anschluß A.

Andere Ausführungsformen der Erfindung unterscheidet sich von den oben beschriebenen dadurch, daß die einzelnen Halbleiterteile durch solche der jeweils entgegengesetzten Leitfähigkeitstypen ersetzt sind, wobei dann Spannungen der entgegengesetzten Polarität zugeführt werden.

Neben diesen Ausführungsformen der Erfindung umfaßt der Erfindungsgedanke auch andere integrierte Schaltungen in komplementärer Schaltungstechnik, bei denen wenigstens zwei Feldeffekttransistoren unterschiedlicher Kanaltypen in einem Halbleiterkörper so integriert sind, daß wenigstens einer von ihnen, der einem ersten Kanaltyp angehört, in einer wannenförmigen Zone liegt, die eine zum Halbleiterkörper entgegengesetzte Leitfähigkeit aufweist, während wenigstens ein anderer, der einem zweiten Kanaltyp angehört, außerhalb dieser Zone auf dem Halbleiterkörper angeordnet ist. Die wannenförmige Zone ist dabei stets mit einer Versorgungsspannung beschaltet.

Die oben anhand der Transistoren T1 und T2 beschriebene parasitäre Thyristorwirkung, die bei jeder Schaltung dieser Art auftreten kann, wird durch die Einfügung einer Schottky-Diode zwischen ein Anschlußgebiet des in der wannenförmigen Zone liegenden Feldeffekttransistors und den Anschluß der Versorgungsspannung dann unterbunden, wenn die vordere Schwellwertspannung $V_D$ der Schottky-Diode kleiner gewählt ist als die vordere Schwellwertspannung des pn-Übergangs zwischen diesem Anschlußgebiet und der wannenförmigen Zone.

5 Patentansprüche
7 Figuren

## Patentansprüche

1. Integrierte Schaltung in komplementärer Schaltungstechnik mit wenigstens zwei MIS-Feldeffekttransistoren (T1, T2) unterschiedlicher Kanaltypen, von denen ein erster (T2) in einem dotierten Halbleiterkörper (1) eines ersten Leitfähigkeitstyps und ein zweiter (T1) in einer im Halbleiterkörper vorgesehenen wannenförmigen Halbleiterzone (2) eines zweiten Leitfähigkeitstyps angeordnet ist, wobei die Halbleiterzone (2) mit einer Versorgungsspannung ($V_{DD}$) beschaltet ist und der erste Feldeffekttransistor (T2) mit einem Sourceanschluß (22) versehen ist, der auf einem Bezugspotential ($V_{SS}$) liegt, d a d u r c h  g e k e n n z e i c h n e t , daß an der Oberfläche eines in den Halbleiterkörper (1) eingefügten, entgegengesetzt zu diesem dotierten Halbleitergebiets (2') ein Metallkontakt (29) vorgesehen ist, der mit diesem Halbleitergebiet (2') eine Schottky-Diode (D) bildet, und daß der Metallkontakt (29) mit einem Anschlußgebiet (5) des zweiten Feldeffekttransistors (T1) verbunden ist, während das Halbleitergebiet (2') mit der Versorgungsspannung ($V_{DD}$) beschaltet ist.

2. Integrierte Schaltung  nach Anspruch 1, d a d u r c h  g e k e n n z e i c h n e t , daß das Halbleitergebiet aus der in dem Halbleiterkörper (1) vorgesehenen wannenförmigen Halbleiterzone (2) besteht.

3. Integrierte Schaltung nach Anspruch 2, d a d u r c h  g e k e n n z e i c h n e t , daß der Metallkontakt aus dem ersten Teil einer leitenden Belegung (12') besteht, die im Bereich eines Kontaktfensters (13') in einer den Halbleiterkörper (1) bedeckenden Isolierschicht (8) angeordnet ist, und mit einem weiteren Teil das Anschlußgebiet (5') des zweiten Feldeffekttransistors (T1) kontaktiert.

4. Integrierte Schaltung nach einem der Ansprüche 1 bis 3, d a d u r c h   g e k e n n z e i c h n e t , daß der erste und zweite Feldeffekttransistor (T2, T1) einen Inverter bilden, wobei ihre Gateanschlüsse mit einem gemeinsamen Schaltungseingang (E) und ihre Drainanschlüsse mit einem gemeinsamen Schaltungsausgang (A) verbunden sind, während der Sourceanschluß des zweiten Feldeffekttransistors (T1) mit der Versorgungsspannung ($V_{DD}$) beschaltet ist.

5. Verfahren zur Herstellung einer integrierten Schaltung nach Anspruch 2, d a d u r c h   g e k e n n - z e i c h n e t , daß von einem Körper (1) aus dotiertem Halbleitermaterial eines ersten Leitungstyps ausgegangen wird, der auf einer Grenzfläche (1a) von Feldisolationsbereichen (3a bis 3e) und Gateisolationsbereichen (S1 bis S4) bedeckt ist und eine wannenförmige Zone (2) des zweiten Leitungstyps aufweist, die sich bis zur Grenzfläche (1a) hin erstreckt, daß auf der Isolationsschicht eine polykristalline Siliziumschicht aufgebracht und durch fotolithografische Schritte strukturiert wird, so daß wenigstens auf einem Gateisolationsbereich (S1) oberhalb der wannenförmigen Zone (2) und auf einem weiteren Gateisolationsbereich (S4) außerhalb derselben Gates (6, 16) von Feldeffekttransistoren gebildet werden, daß durch eine Ionenimplantation (Im1), bei der der oberhalb der wannenförmigen Zone (2) liegende Teil der Isolationsschicht mit Ausnahme eines Teilbereichs oberhalb eines Anschlußgebiets (23) dieser Zone durch eine Implantationsmaske (L1), insbesondere eine Fotolackschicht, abgedeckt ist, die Source- und Draingebiete (14, 15) der außerhalb der Zone (2) liegenden Feldeffekttransistoren und das Anschlußgebiet (23) der Zone erzeugt werden, daß durch eine weitere Ionenimplantation (Im2), bei der der außerhalb der wannenförmigen Zone (2) liegende Teil der Isolationsschicht durch eine weitere Implantationsmaske (L2), insbesondere eine weitere Fotolackschicht, abgedeckt ist, die Source- und Draingebiete (4, 5) der innerhalb der Zone liegenden Feldeffekttransistoren erzeugt werden, daß einer der Gateisolationsbereiche (S2), der oberhalb der wannenförmigen Zone angeordnet ist, durch die Implantationsmasken beider Ionenimplantationen abgedeckt wird, daß anschließend eine Zwischenisolationsschicht (8) aufgebracht wird, die oberhalb der Source- und Draingebiete der Feldeffekttransistoren, oberhalb des Anschlußgebiets (23) der Zone und oberhalb des durch beide Implantationsmasken abgedeckten Gateisolationsbereichs (S2) mit Fenstern versehen wird, die sich bis zur Grenzfläche (1a) des Körpers (1) hin erstrecken, daß anschließend auf der Zwischenisolationsschicht (8) leitende Belegungen (9, 12, 24, 18 und 20) aufgebracht werden, die in den Bereichen der Fenster die darunterliegenden Teile des Körpers (1) jeweils kontaktieren und daß diese leitenden Belegungen mit Anschlüssen (11, 22) für die Zuführung der Versorgungsspannung und des Bezugspotentials versehen werden.

# FIG 1

# FIG 2

0 166 386
84 P 1 471 E

FIG 3

FIG 4

0 166 386

## FIG 5

L1    Im 1

3a    6    S1    3b    S2    3c    S3    3d    S4    16    1a    3e    1    2

## FIG 6

Im2    L2    16    S3

3a    6    S1    3b    S2    3c    23    3d    15    1a    S4    14    3e    1    2

## FIG 7

8    10    6    13    25    24a    19    16    21    8
3a    4    7    5    3b    3c    23    3d    15    1a    17    14    3e    1    2    D